# EUROPÄISCHE PATENTANMELDUNG

(11) **EP 1 609 882 A1**
(43) Veröffentlichungstag der Anmeldung: **28.12.2005**
(21) Anmeldenummer: 04405394.0
(22) Anmeldetag: 24.06.2004
(51) Int. Cl.: C23C 14/35, H01J 37/34

(54) **Kathodenzerstäubungsvorrichtung und -verfahren**

(71) Anmelder: METAPLAS IONON Oberflächenveredelungstechnik GmbH, D-51427 Bergisch Gladbach (DE)
(72) Erfinder: Vetter, Jörg, 51469 Bergisch Gladbach (DE)
(74) Vertreter: Sulzer Management AG

(57) **Zusammenfassung**

Die Erfindung betrifft eine Beschichtungsvorrichtung (1) mit einer Prozesskammer (2) zum Beschichten eines Substrats (S) mittels Kathodenzerstäubung, welche Prozesskammer (2) zur Errichtung und Aufrechterhaltung einer Gasatmosphäre einen Einlass (3) und einen Auslass (4) für ein Prozessgas aufweist, sowie eine Anode (5) und eine Kathode (6) mit einem Target (61) aus dem zu zerstäubenden Targetmaterial (62), und eine elektrische Energiequelle (7) zur Erzeugung einer elektrischen Spannung zwischen der Anode (5) und der Kathode (6), wobei die elektrische Energiequelle (7) eine elektrische Zerstäubungsquelle (8) umfasst, mit welcher das Targetmaterial (62) der Kathode (6) durch Zerstäubung in eine Dampfform überführbar ist. Weiterhin sind lonisierungsmittel (9) zur Erzeugung einer elektrischen lonisierungspannung (91) vorgesehen, so dass das zerstäubte Targetmaterial (62) zumindest teilweise ionisierbar ist, wobei eine Filtereinrichtung (10) mit einer magnetischen Führungskomponente (11) vorgesehen ist, welche Filtereinrichtung (10) derart ausgestaltet und angeordnet ist, dass das zerstäubte ionisierte Targetmaterial (622) durch die magnetische Führungskomponente (11) einer Oberfläche des zu beschichtenden Substrats (S) zuführbar ist und das zerstäubte nicht-ionisierte Targetmaterial (623, 62434) durch die Filtereinrichtung (10) vor Erreichen der Oberfläche des Substrats (S) ausfilterbar ist.

## Beschreibung

Die Erfindung betrifft eine Beschichtungsvorrichtung zum Beschichten eines Substrats, ein Verfahren zum Beschichten, sowie ein beschichtetes Substrat gemäss dem Oberbegriff des unabhängigen Anspruchs der jeweiligen Kategorie.

Zum Aufbringen von Schichten oder Schichtsystemen auf die unterschiedlichsten Substrate sind aus dem Stand der Technik eine ganze Reihe verschiedener chemischer, mechanischer und physikalischer Techniken bekannt, die je nach Anforderung und Einsatzgebiet ihre Berechtigung haben und entsprechende Vor- und Nachteile aufweisen.

Zum Aufbringen verhältnismässig dünner Schichten sind insbesondere Verfahren geläufig, bei welchen die Oberfläche eines Targets in einem Lichtbogen in die Dampfform überführt wird, wobei sich der so gebildete Dampf dann als Beschichtung auf einem Substrat niederschlagen kann. Hier sind die Verfahren der anodischen und der kathodischen Vakuumbogenverdampfung zu nennen. Ein Nachteil dieser Verfahren besteht darin, dass bei der Verdampfung des Targets, z.B. eines Targets, das Kohlenstoff oder ein Metall wie z.B. Kupfer enthält, immer Makropartikel, sogenannte Droplets auftreten, die aufwendig ausgefiltert werden müssen, wenn z.B. an die Gleichmässigkeit der aufzubringenden Schicht höchste Qualitätsansprüche gestellt werden. Dabei gelingt in der Regel die Ausfilterung der Droplets nur ungenügend, was natürlich die Qualität der entstehenden Schichten negativ beeinflusst.

Insbesondere zur Darstellung ultradünner defektfreier Schichten wird daher häufig auf die bekannten Verfahren der Kathodenzerstäubung mittels eines ionisierten Prozessgases, wie beispielsweise Argon zurückgegriffen. Diese Zerstäubungsverfahren sind in ihren unterschiedlichen Varianten dem Fachmann unter dem Bergriff "Sputtern" geläufig.

Die Partikelemission von Droplets ist beim Sputtern naturgemäss viel geringer als beim Lichtbogenverdampfen, da das Targetmaterial eher "schonend" durch einzelne ionisierte Atome des Prozessgases unter Einwirkung eines elektrischen Feldes aus dem Target herausgelöst und in die Dampfform überführt wird. D.h., beim Sputtern wird das Tragetmaterial nicht wie beim Lichtbogenverdampfen, durch Schmelzen von Teilen der Oberfläche des Targets in die Gasphase überführt.

Allerdings besteht auch beim Sputtern, also beim Zerstäuben der Oberfläche eines Targets durch ein ionisiertes Prozessgas eine gewisse Gefahr der Partikelemissionen durch parasitäre Entladungen, z.B. durch die Entstehung von sogenannten "Mikrobögen" aufgrund mehr oder weniger spontaner elektrischer Entladungen durch elektrisch inhomogene Verhältnisse. Dabei können unter anderem aufgrund der vorgenannten parasitären Entladungen im Rahmen der Partikelemissionen Droplets in einer Grösse von ca. 10nm-500nm entstehen, wobei die Grösse der Droplets in bestimmten Fällen auch bedeutend grösser oder kleiner sein kann.

Die vorgenannten Partikelemissionen, auch wenn diese im Vergleich zu den Emissionen beim Lichtbogenverdampfen in Grösse und im Umfang deutlich geringer sind, sind insbesondere bei der Herstellung ultradünner Schichten, oder wenn extrem glatte Oberfläche wie beispielsweise bei optischen oder elektronischen Bauteilen, wie Linsen, Festplatten, usw. häufig nicht akzeptabel.

Aufgabe der Erfindung ist es daher, eine Beschichtungsvorrichtung und ein Verfahren zum Beschichten mittels Kathodenzerstäubung, vorzuschlagen mit welchem Substrate, insbesondere optische, mikromechanische und elektronische Komponenten, weitgehend defektfrei beschichtbar sind, so dass die beschichteten Oberflächen allerhöchsten Qualitätsanforderungen genügen.

Die diese Aufgaben in apparativer und verfahrenstechnischer Hinsicht lösenden Gegenstände der Erfindung sind durch die Merkmale des unabhängigen Anspruchs der jeweiligen Kategorie gekennzeichnet.

Die abhängigen Ansprüche beziehen sich auf besonders vorteilhafte Ausführungsformen der Erfindung.

Die erfindungsgemässe Beschichtungsvorrichtung mit einer Prozesskammer zum Beschichten eines Substrats mittels Kathodenzerstäubung, welche Prozesskammer zur Errichtung und Aufrechterhaltung einer Gasatmosphäre einen Einlass und einen Auslass für ein Prozessgas aufweist, umfasst eine Anode und eine Kathode mit einem Target aus dem zu zerstäubenden Targetmaterial, eine elektrische Energiequelle zur Erzeugung einer elektrischen Spannung zwischen der Anode und der Kathode, wobei die elektrische Energiequelle eine elektrische Zerstäubungsquelle umfasst, mit welcher das Targetmaterial der Kathode durch Zerstäubung in eine Dampfform überführbar ist. Weiterhin sind Ionisierungsmittel zur Erzeugung einer elektrischen Ionisierungsspannung vorgesehen, so dass das zerstäubte Targetmaterial zumindest teilweise ionisierbar ist, wobei eine Filtereinrichtung mit einer magnetischen Führungskomponente vorgesehen ist, welche Filtereinrichtung derart ausgestaltet und angeordnet ist, dass das zerstäubte ionisierte Targetmaterial durch die magnetische Führungskomponente einer Oberfläche des zu beschichtenden Substrats zuführbar ist und das zerstäubte nicht-ionisierte Targetmaterial durch die Filtereinrichtung vor Erreichen der Oberfläche des Substrats ausfilterbar ist.

Mit der erfindungsgemässen Beschichtungsvorrichtung ist es somit möglich, einer zu beschichtenden Oberfläche eines Substrats im wesentlichen nur den ionisierten Anteil des zerstäubten Targetmaterials zuzuführen und nicht ionisierte Anteile vor Erreichen des zu beschichtenden Substrats auszufiltern. Dadurch wird insbesondere verhindert, dass tröpfchenförmige Ansammlungen von Teilchen, sogenannte Droplets, die sich beim Zerstäubungsvorgang vom Target an der Kathode gelöst haben, die Oberfläche des Substrats erreichen. Dabei wird die Zahl der ionisierten zerstäubten Teilchen massiv erhöht, indem das zerstäubte Material, das sich grösstenteils in der Gasphase befindet, durch die Ionisierungsmittel durch Anlegen einer lonsierungsspannung ionisiert wird, wodurch der Anteil der ionisierten Teilchen bis zu 50%, je nach Prozessführung zwischen 50% und 75% oder im speziellen auch über 75% liegen kann. Das ist dadurch erreichbar, dass zur Ionisierung hohe, bevorzugt gepulste Ionisierungsspannungen im Bereich von z.B. 1000V bei extrem hohen elektrischen Strömen von z.B. 1000A Verwendung finden. Das entspricht elektrischen Leistungen im Megawatt-Bereich, wobei mit Pulsfrequenzen der Ionisierungsspannung bis zu einigen KHz, bevorzugt mit Pulsfrequenzen bis 100Hz, im speziellen z.B. mit einer Pulsfrequenz von 50Hz gearbeitet wird. Diese Kathodenzerstäubungstechnik, die mit Hilfe von Ionisierungsmitteln zerstäubtes Targetmaterial der Kathode ionisiert, ein Prozess, der auch untem dem Begriff "Nach-Ionisierung" geläufig ist, wird oft auch als "Hochleistungssputtern" bezeichnet, eine an sich bekannte Sputtertechnik, die z.B. in der WO 02/103078 eingehend beschrieben ist, bei welcher mit hohen elektrischen Leistungen das zerstäubte, oft grösstenteil elektrisch neutrale Material, nach-ionisiert wird.

Die Ionisierungsmittel können z.B. einfach eine Spannungsquelle umfassen, die z.B. elektrisch mit der Anode und der Kathode verbunden sind, so dass beispielsweise eine geeignete gepulste Spannung zwischen Anode und Kathode anlegbar ist, wodurch zerstäubtes Targetmaterial ionisierbar ist. Dabei kann die Zerstäubungsquelle und die Ionisierungsmittel durch ein und dieselbe Spannungsquelle gebildet werden, die durch geeignete Steuerung und/oder Regelung dieser Spannungsquelle beispielsweise abwechselnd oder gleichzeitig eine Zerstäubung des Targets und eine Nach-Ionisation des zerstäubten Materials bewirkt wird. Natürlich ist es auch möglich, dass zwei oder mehr Spannungsquellen zum Einsatz kommen, die alle gemeinsam zwischen Anode und Kathode geschaltet sind, wobei z.B. eine Spannungsquelle nur zur Zerstäubung des Materials dient und eine weitere Spannungsquelle eine geeignete Ionisierungsspannung zur Nach-Ionisierung des zerstäubten Targetmaterials zur Verfügung stellt.

Weiter können die Ionisierungsmittel natürlich auch eine oder mehrere eigene Elektroden umfassen, so dass die elektrische Ionisierungsspannung von der elektrischen Zerstäubungsquelle ganz oder teilweise isoliert ist. Zum Beispiel können die Ionisierungsmittel ein galvanisch von der Anode und der Kathode getrenntes Elektrodensystem umfassen, an welches zur Nach-Ionisierung die elektrische Ionisierungsspannung anlegbar ist.

Die zuvor erläuterten Beispiele von Ionisierungsmitteln sind selbstverständlich nur exemplarisch zu verstehen, d.h. diese Aufzählung von Beispielen möglicher Ausführungsformen von Inonisierungsmitteln ist keineswegs abschliessend. Vielmehr kommt es im wesentlichen nur darauf an, dass durch die Ionisierungsmittel ein ausreichender Grad an ionisiertem Targetmaterial bereitgestellt wird, das dann mittels der magnetischen Führungskomponente zur Beschichtung auf das Substrat führbar ist. In ganz speziellen Fällen kann die Nach-Ionisierung z.B. auch durch andere Ionisierungsquellen, wie ionisierende Strahlung, z.B. Röntgenstrahlung, Laserstrahlung oder auf andere Weise erreicht werden.

Durch die massive Erhöhung des Ionisierungsgrades des zerstäubten Targetmaterials auf einen Wert von z.B. 70% ionisiertes Targetmaterial, erhält man eine genügend hohe Ausbeute an Beschichtungsmaterial, das durch die magnetische Führungskomponente der erfindungsgemässen Filtereinrichtung zum Beschichten des Substrats auf dessen Oberfläche auf einem vorgebbaren Weg führbar ist. Die nicht-ionisierten Teilchen und Partikel, wie z.B. die Droplets, sind in ihrer Bewegung vom magnetischen Feld der magnetischen Führungskomponente im wesentlichen nicht beeinflussbar und werden daher durch die Filtereinrichtung nicht dem zu beschichtenden Substrat zugeleitet.

Im einfachsten Fall wird die Filtereinrichtung einfach durch eine oder mehrere magnetfelderzeugende Quellen gebildet, welche die magnetischen Führungskomponenten sind, die ein derart gestaltetes Magnetfeld zur Führung der ionisierten zerstäubten Teilchen bilden, so dass diese durch das Magnetfeld der magnetfelderzeugenden Quellen auf einer vorgebbaren, geeignet gekrümmten Bahn, auf die zubeschichtende Oberfläche des Substrats geführt werden. Die nicht ionisierten Teilchen, insbesondere die Droplets, die durch die elektrische Ionisierungspannung im wesentlichen nicht ionisiert werden, werden durch das Magnetfeld der magnetischen Führungskomponenten praktisch nicht beeinflusst und folgen in ihrer Bewegung daher nicht der gekrümmten Bahn des Magnetfeldes, so dass die nicht-ionisierten Teilchen die Oberfläche nicht erreichen, sondern in der Prozesskammer, z.B. an deren Wänden, oder z.B. an geeignet angebrachten Auffangeinrichtungen, z.B. an Auffangblechen oder Auffangblenden, abgeschieden werden.

In einem bevorzugten Ausführungsbeispiel umfasst die Filtereinrichtung zumindest einen in Form eines entlang einer Längsachse sich erstreckenden Schlauchs ausgebildeten Abschnitt, der eine Eintrittsöffnung und eine Austrittsöffnung für das zerstäubte Targetmaterial aufweist. Dabei kann der Schlauch aus einem einzigen Abschnitt bestehen, oder aus mehreren zusammengesetzten Abschnitten, die unmittelbar aneinandergesetzt oder in gewissem Abstand zueinander angeordnet sein können.

Im speziellen kann der Schlauch aus einem einzigen geeignet gekrümmten Abschnitt bestehen, wobei der Schlauchs in Bezug auf das Target bzw. die Kathode und in Bezug auf das Substrat so angeordnet ist, dass die zerstäubten Teilchen durch eine Eintrittsöffnung in den Schlauch eintreten, wobei die ionisierten Teilchen durch die magnetische Führungskomponente im Schlauch so geführt werden, und dass sie durch eine Austrittsöffnung den Schlauch in Richtung des zu beschichtenden Substrat wieder verlassen, so dass die ionisierten Teilchen im Schlauch durch die magnetische Führungskomponente zur Beschichtung auf das Substrat führbar sind.

Die nicht ionisierten Teilchen, wie beispielsweise die Droplets, folgen dem gekrümmten Verlauf nicht und werden daher an den Wänden des Schlauchs abgeschieden und erreichen die Oberfläche des zu beschichtenden Substrats nicht. Diese Variante der erfindungsgemässen Beschichtungsvorrichtung hat unter anderem den besonderen Vorteil, dass die Prozesskammer im wesentlichen nicht oder nur wenig von dem auf dem Substrat nicht abgeschiedenen Targetmaterial verschmutzt wird. Bevorzugt ist der Schlauch so in der Prozesskammer angeordnet, dass er ohne die magnetische Führungskomponente zu demontieren, ausgetauscht werden kann.

In einem speziellen Ausführungsbeispiel ist der Schlauch mit Target und Zerstäuubungsquelle so ausgestaltet und angeordnet, das der Schlauch selbst im wesentlichen ganz ausserhalb der Prozesskammer vorgesehen ist und die Austrittsöffnung des Schlauchs mit einer Öffnung der Prozesskammer derart zusammenwirkt, dass das ionisierte Targetmaterial aus dem Schlauch ins innere der Kammer zur Beschichtung eines in der Prozesskammer angeordneten Substrats führbar ist. Diese Variante hat den besonderen Vorteil, dass die Beschichtungskammer relativ klein gehalten werden kann und der Schlauch besonders leicht austauschbar ist.

Besteht der Schlauch aus mehreren einzelnen Abschnitten, die zum Beispiel beabstandet voneinander angeordnet sind, brauchen die einzelnen Abschnitte als solche nicht unbedingt gekrümmt zu sein. Vielmehr bildet in einem speziellen Ausführungsbeispiel die Anordnung mehrerer Abschnitte insgesamt eine gekrümmte Bahn, der durch geeignete Ausgestaltung und Anordnung der magnetischen Führungskomponente die ionisierten Teilchen in Richtung auf das Substrat folgen. Die einzelnen Abschnitte können dabei jedes für sich oder auch nur einzelne, gerade ausgebildet sein, obwohl die gesamte Anordnung eine mehr oder weniger gekrümmte Bahn bildet. Dadurch ist es beispielsweise möglich, im Wartungsfall z.B. nur einzelne Abschnitte auszutauschen. Insbesondere können durch den abschnittsweisen Aufbau der Anordnung auch komplizierte Krümmungsgeometrien leicht montiert oder demontiert werden.

In einem bevorzugten Ausführungsbeispiel weist der Schlauch in Bezug auf die Längsachse in einer Krümmungsebene mindestens eine Biegung mit einem vorgebbaren Biegungswinkel auf. So kann der Schlauch z.B. unter einem beliebigen Winkel gebogen sein. Spezielle Biegungswinkel liegen unterhalb von 45°, zwischen 30° und 180°, bevorzugt zwischen 70° und 120°, im besonderen kann der Schlauch eine Biegung von ca. 90° aufweisen.

Besonders gute Filterergebnisse sind erzielbar, wenn der Schlauch eine kompliziertere Krümmungsgeometrie aufweist. So kann der Schlauch in Bezug auf eine Krümmungsebene mehrere Biegungen, eventuell, aber nicht notwendig, in entgegengesetzte Richtungen aufweisen. Auch kann der Schlauch in Bezug auf mindestens zwei verschiedene Krümmungsebenen Biegungen aufweist. So ist beispielsweise in einem vorgebbaren Abschnitt bezüglich der Längsachse eine spiralförmige Krümmung denkbar. Dabei ist grundsätzlich jedoch jede geeignete Geometrie für die Krümmung des Schlauchs denkbar, die es gestattet, einen genügend hohen Anteil der ionisierten zerstäubten Teilchen auf das zu beschichtende Substrat zu leiten.

Der Schlauch selbst kann je nach Anwendung und Anforderungen aus jedem geeigneten Material bestehen und auf jede geeignete Weise aufgebaut sein. Bevorzugt, aber nicht notwendig, ist der Schlauch aus geeigneten Kunststoffen oder Verbundwerkstoffen ausgebildet oder kann aus Metall oder aus Metallgeflechten bestehen, die magnetisch oder unmagnetisch sein können. Ist der Schlauch selbst ganz oder teilweise aus magnetischen Materialien aufgebaut, so kann der Schlauch selbst Teil der magnetischen Führungskomponente sein und zur Führung der ionisierten Teilchen beitragen.

Die magnetische Führungskomponente zur Erzeugung eines magnetischen Führungsfeldes, welches typische Feldstärken bis zu einigen 1000 Gauss, im speziellen bis zu 1000 Gauss, im besonderen zwischen 10 und 500 Gauss liefert, kann z.B. eine elektrische Magnetsspule, bevorzugt eine Helmholtzspule umfassen. In einem für die Praxis wichtigen Beispiel sind mehrere Spulen vorgesehen, so dass das durch die magnetische Führungskomponente erzeugte Magnetfeld besonders gut an die zu führenden ionisierten Teilchen angepasst werden kann. So können z.B. Regelmittel vorgesehen sein, so dass die Form und die Stärke des durch die magnetische Führungskomponente erzeugten magnetischen Führungsfeldes sowohl in Abhängigkeit vom Ort, als auch in Abhängigkeit von der Zeit gesteuert und / oder geregelt werden kann. So ist es z.B. möglich, die Menge an Beschichtungsmaterial, die pro Zeiteinheit das Substrat erreichen soll, gezielt zu steuern oder zu regeln, in dem das Magnetfeld der magnetischen Führungskomponente entsprechend gesteuert wird, wobei die Zerstäubung des Targets z.B. unter stabilen Bedingungen weiter fortgesetzt werden kann.

Dadurch ist es unter anderem möglich, wie unten noch näher beschrieben wird, verschiedene Substrate durch Zerstäuben ein und desselben Targets unter unterschiedlichen Bedingungen zu beschichten. Oder aber ein und dasselbe Substrat z.B. aus der Zerstäubung von zwei oder mehr verschiedenen Targets mit Beschichtungsmaterial zu beschichten, wobei die verschiedenen Targets insbesondere aus verschiedenen Targetmaterialien bestehen können und bevorzugt von jedem Target eine separate Filtereinrichtung zu dem zu beschichtenden Substrat führt. Damit ist es möglich, ein Substrat gleichzeitig oder nacheinander mit verschiedenen oder gleichen Materialien gezielt zu beschichten, wobei durch Steuerung und / oder Regelung der magnetischen Führungskomponente auf besonders einfache Weise die Parameter der aufzutragenden Schicht, wie z.B. Schichtdicke, Schichtzusammensetzung, physikalische und chemische Eigenschaften usw. einstellbar sind.

Dabei kann selbstverständlich die magnetische Führungskomponente zur Erzeugung eines magnetischen Führungsfeldes auch einen oder mehrere Permanentmagnete umfassen oder Kombinationen von Spulen und Permanentmagneten bilden oder stromdurchflossene Drähte oder jede andere geeignete magnetfelderzeugende Komponente umfassen, wobei die magnetische Führungskomponente insbesondere auch einen dem Fachmann wohlbekannten Polschuhmagneten oder jede geeignete Kombination der genannten magnetischen Führungskomponenten umfassen kann.

In einem bevorzugten Ausführungsbeispiel der erfindungsgemässen Beschichtungsvorrichtung ist zur Filterung von nicht-ionisiertem zerstäubtem Targetmaterial mindestens eine Rückhaltblende als Partikelfalle vorgesehen. Diese Partikelfalle kann beispielsweise in der Nähe des Substrats an einer Austrittsöffnung des Schlauchs der Filtereinrichtung vorgesehen sein. Vorteilhaft kann die Partikelfalle natürlich auch an einer beliebigen Stelle innerhalb des Schlauch oder beispielsweise als Rückhalteblende an der Eintrittsöffnung des Schlauchs angeordnet sein. Insbesondere können mehrere Partikelfallen in einem Schlauch vorgesehen sein. In einem speziellen Ausführungsbeispiel weist eine Innenseite des Schlauch eine rippenförmige Struktur auf, welche rippenförmige Struktur so ausgestaltet ist, dass sie als Partikelfalle wirkt, so dass nicht ionisiertes Targetmaterial und /oder auch ionisiertes oder nicht ionisiertes Prozessgas herausfilterbar ist.

In einem speziellen Ausführungsbeispiel fehlt der Schlauch ganz und die Filtereinrichtung wird nur aus einem geeignet angeordneten System einer oder mehrerer Partikelfallen in Verbindung mit der magnetischen Führungskomponente gebildet.

Es versteht sich von selbst, dass alle zuvor beschriebenen Ausführungsvarianten von Partikelfallen auch in geeigneten Kombinationen vorteilhaft Verwendung finden können und die Aufzählung möglicher Partikelfallen nicht abschliessend ist.

Zur Steuerung und / oder Regelung der Konzentration an ionisiertem Prozessgas, das z.B. Argon, ein anderes Edelgas oder auch jedes andere geeignete Prozessgas, wie z.B. Stickstoff, Sauerstoff, usw. sein kann, kann zur Neutralisation des Prozessgases, insbesondere zur Neutralisation von Argon, eine Elektronenquelle zur Injektion von Elektronen vorgesehen sein, mit welcher Ionen des Prozessgases und / oder des gesputterten Materials neutralisierbar sind, wobei die Neutralisation des gesputterten Materials bevorzugt am Ende des Schlauchs bzw. am Ende der magnetischen Führungskomponente stattfindet.

Um den Beschichtungsvorgang des Substrats mit den ionisierten Teilchen zu optimieren, ist in einem besonderen Ausführungsbeispiel das Substrat und /oder ein Substrathalter für das Substrat auf ein vorgebbares elektrisches positives oder negatives Potential einstellbar.

Für spezielle Anwendungen umfasst die Prozesskammer eine Zerstäubungskammer, in welcher die Kathode angeordnet ist, und eine Beschichtungskammer, in welcher das Substrat angeordnet ist. Die Zerstäubungskammer und die Beschichtungskammer sind dabei durch die Filtereinrichtung miteinander verbunden, wobei jedoch auch weitere Verbindungen zwischen Zerstäubungskammer und Beschichtungskammer bestehen können. Dabei kann in der Zerstäubungskammer und in der Prozesskammer dieselbe Gasatmosphäre herrschen oder aber die Gasatmosphäre in der Prozesskammer und in der Zerstäubungskammer können sich je nach Anforderung mehr oder weniger stark verschieden sein, und es können entsprechende Mittel vorgesehen sein, um eventuell die Gasatmosphäre in den jeweiligen Kammern getrennt oder gemeinsam zu Steuern und / oder zu Regeln.

Dabei können in ein und derselben Prozesskammer bzw. in ein und derselben Zerstäubungskammer, wie oben bereits erläutert, auch mehr als eine Kathode und / oder mehr als eine Anode vorgesehen sein, so dass z.B. gleichzeitig oder nacheinander verschiedene Kathoden aus gleichem oder verschiedenem Targetmaterial zerstäubbar sind, so dass z.B. ein Substrat gleichzeitig oder in einer vorgebbaren Abfolge mit verschiedenen Materialien beschichtbar ist.

Selbstverständlich ist es auch möglich, dass die Beschichtungsvorrichtung derart ausgestaltet ist, dass mindestens zwei verschiedene Substrate in ein und derselben Beschichtungskammer oder in verschiedenen Beschichtungskammern beschichtbar sind.

Dazu kann eine erfindungsgemässe Beschichtungsvorrichtung mehr als eine Zerstäubungskammer und / oder mehr als eine Beschichtungskammer umfassen.

Als Targetmaterial zur Beschichtung des Substrats kommen grundsätzlich alle geeigneten Targetmaterialien in Frage, wobei das Target bevorzugt Kohlenstoff oder Kohlenstoffverbindungen, oder auch Metalle oder Metalllegierungen, insbesondere Kupfer umfasst.

Zur Verbesserung der Zerstäubungseigenschaften der erfindungsgemässen Beschichtungsvorrichtung ist bevorzugt, aber nicht notwendig, ein Magnetsystem vorgesehen, umfassend die Kathode und entsprechende Kühl-und Haltemittel, und das Magnetsystem bevorzugt als Magnetron ausgebildet ist, wobei das Magnetron ein balanziertes oder ein unbalanziertes Magnetron sein kann. Der Einsatz und die Verwendung von Magnetrons aller Art im Rahmen der hier beschriebenen, häufig als Sputtern bezeichneten Beschichtungstechnik, ist dem Fachmann wohlbekannt und braucht daher nicht im Detail beschrieben zu werden.

Es versteht sich von selbst, dass die erfindungsgemässe Beschichtungsvorrichtung zum Beschichten eines Substrats, nicht auf bestimmte Zerstäubungstechniken, d.h. Sputtertechniken beschränkt ist. Vielmehr können alle Varianten des Sputterns vorteilhaft in der erfindungsgemässen Beschichtungsvorrichtung zum Einsatz kommen, wenn nur die Konzentration des ionisierten zerstäubten Targetmaterials durch die Ionisierungsmittel auf eine ausreichende vorgebbare Konzentration erhöhbar ist. Insbesondere sind die zuvor erläuterten bevorzugten Ausführungsbeispiele der erfindungsgemässen Beschichtungsvorrichtung nur exemplarisch und keinesfalls ist diese Aufzählung abschliessend zu verstehen. Vielmehr sind alle sinnvoll möglichen Kombinationen der beschriebenen Ausführungsbeispiele für bestimmte Anwendungen ebenfalls möglich und können vorteilhaft zum Beschichten von Substraten Verwendung finden.

Das erfindungsgemässe Verfahren zum Beschichten eines Substrats mittels Kathodenzerstäubung wird in einer Beschichtungsvorrichtung mit einer Prozesskammer durchgeführt, wobei die Beschichtungsvorrichtung eine Zerstäubungskammer mit einem Einlass und einem Auslass für ein Prozessgas umfasst, in der eine Gasathmosphere errichtet wird. Weiter umfasst die Beschichtungsvorrichtung eine Anode und eine Kathode mit einem Target aus einem Targetmaterial, das zur Beschichtung des Substrats zerstäubt wird und eine elektrische Energiequelle, mit welcher eine elektrische Spannung zwischen der Anode und der Kathode erzeugt wird, wobei die elektrische Energiequelle eine elektrische Zerstäubungsquelle aufweist, mit welcher das Targetmaterial der Kathode durch Zerstäubung in eine Dampfform überführt wird, und Ionisierungsmittel zur Erzeugung einer elektrischen Ionisierungsspannung vorgesehen ist, mit welcher das zerstäubte Targetmaterial zumindest teilweise ionisiert wird. Dabei ist eine Filtereinrichtung mit einer magnetischen Führungskomponente vorgesehen, welche Filtereinrichtung derart ausgestaltet und angeordnet ist, dass das zerstäubte ionisierte Targetmaterial durch die magnetische Führungskomponente einer Oberfläche des zu beschichtenden Substrats zumindest teilweise zugeführt wird und das zerstäubte nicht-ionisierte Targetmaterial durch die Filtereinrichtung vor Erreichen der Oberfläche des Substrats zu einem vorgebbaren Anteil ausgefiltert wird.

Erfindungsgemäss wird weiter ein Substrat, insbesondere ein optisches oder elektronisches Bauteil, im speziellen eine Computerfestplatte, mittels der erfindungsgemässen Beschichtungsvorrichtung und / oder gemäss dem erfindungsgemässen Verfahren beschichtet. Dabei versteht sich von selbst, dass selbstverständlich ausser den zuvor genannten speziellen Beispielen auch alle anderen Substrate, wie mechanische und technische Komponenten, an welche höchste Qualitätsansprüche an die beschichtete Oberfläche gestellt werden oder auch z.B. im Bereich ästhetischer Anwendungen, wie Schmuck oder bei Verzierungen aller Art das erfindungsgemässe Verfahren bzw. die erfindungsgemässe Beschichtungsvorrichtung mit Vorteil einsetzbar ist.

Dabei ist die erfindungsgemässe Beschichtungsvorrichtung und das erfindungsgemässe Verfahren insbesondere im Bereich der Mikromechanik, der Mikroelektronik, z.B. in der Medizintechnik und / oder zur Beschichtung von Elementen der Nanosensorik oder für Nanomotoren besonders vorteilhaft einsetzbar.

Die Erfindung wird im folgenden an Hand der schematischen Zeichnung näher erläutert. Es zeigen:
- Fig. 1: ein einfaches Ausführungsbeispiel einer erfindungsgemässen Beschichtungsvorrichtung;
- Fig. 2: ein zweites Ausführungsbeispiel gemäss Fig. 1 mit einem Schlauch;
- Fig. 2a: ein ausserhalb der Prozesskammer angeordneter Schlauch;
- Fig. 3: eine Filtereinrichtung mit einem mehrfach gebogenen Schlauch;
- Fig. 4: eine Beschichtungsvorrichtung mit separater Zerstäubunggskammer und Beschichtungskammer;
- Fig. 5: eine Beschichtungsvorrichtung mit zwei Zerstäubungseinheiten;

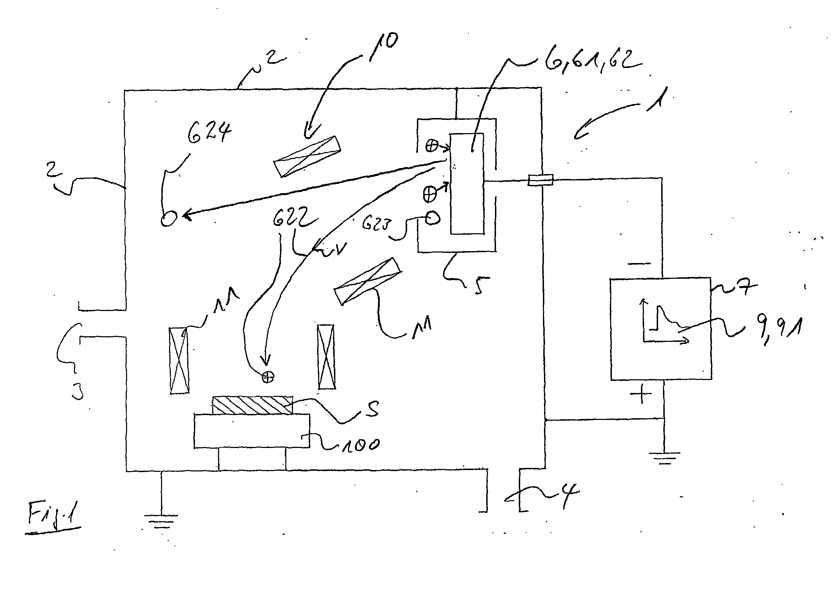

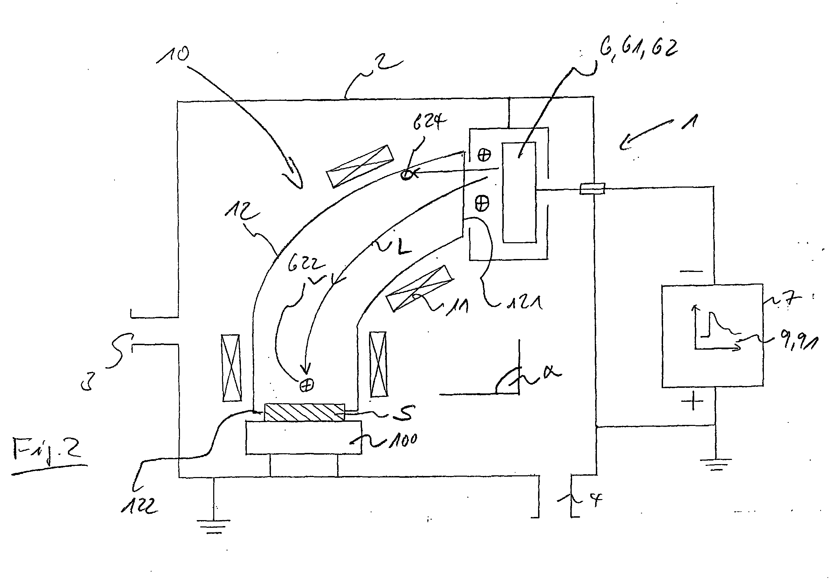

Fig. 1 zeigt in einer schematischen Darstellung ein einfaches Ausführungsbeispiel einer erfindungsgemässen Beschichtungsvorrichtung, die im folgenden mit dem Bezugszeichen 1 bezeichnet wird. Die Beschichtungsvorrichtung 1 zum Beschichten eines Substrats S, z.B. zum Beschichten einer Oberfläche einer Computerfestplatte S oder einer empfindlichen optischen Komponente S, umfasst eine Prozesskammer 2 zur Errichtung und Aufrechterhaltung einer Gasatmosphäre, welche Prozesskammer 2 einen Einlass 3 und einen Auslass 4 für ein Prozessgas, welches im vorliegenden Fall Argon ist. In der Beschichtungsvorrichtung 1 ist eine Anode 5 und eine Kathode 6 angeordnet, die mit einer elektrischen Energiequelle 7 mit elektrischer Zerstäubungsquelle 8 verbunden ist und eine Zerstäubungsanordnung bilden, mit welcher das Targetmaterial 62 der Kathode 6 durch Zerstäubung in die Dampfform überführbar ist.

Bei diesem als Sputtern wohlbekannten Prozess werden Ionen des Prozessgases, also hier Argon Ionen, im elektrischen Feld zwischen Anode 5 und Kathode 6 beschleunigt, wobei die positiv geladenen Ionen des Prozessgases auf die negativ geladene Kathode 6 treffen und dabei eine geringe Anzahl positiv geladener Targetionen 622 des Targetmaterials 62 erzeugen, eine sehr viel grössere Anzahl einzelner neutraler, also nicht ionisierter Atome 623 des Targetmaterials 62 aus dem Target 61 erzeugt werden und, z.B. durch Mikrobögen kleine, im wesentlichen ungeladene Tröpfchen 624 des Targetmaterials, sogenannte Droplets 624 erzeugt werden.

An das Elektrodenpaar aus Anode 5 und Kathode 6 ist weiterhin eine pulsförmige elektrische Ionisierungsspannung 91, die vom lonisierungsmittel 9 erzeugt wird, angelegt. Die Ionisierungsspannung 91 beträgt typischerweise bis zu ca. 1000V oder mehr, es können dabei Ströme bis zu 1000A oder höher entstehen, wobei typische Pulsfrequenzen für die Ionisierungsspannung 91 zum Beispiel im Bereich von 50Hz liegen. Durch die angelegte Ionisierungspannung 91 werden die aus dem Target 61 herausgeschlagenen nicht ionisierten Targetatome 623 zu einem erheblichen Teil ionisiert, so dass aus den ungeladenen Targetatomen 623 positiv geladene Targetionen 622 entstehen. Der so erreichte Ionisierungsgrad des sich in der Dampfform befindenden Targetmaterials kann bei entsprechender Prozessführung bis zu 70% und mehr betragen.

Desweiteren ist in der Prozesskammer 2 das zu beschichtende Substrat S an einem Substrathalter 100 angeordnet, der entweder elektrisch isoliert oder im speziellen auch elektrisch leitend mit einer Wand der Prozesskammer 2 oder einer elektrischen Energiequelle verbunden sein kann, die hier nicht gezeigt ist.

Erfindungsgemäss ist eine Filtereinrichtung 10 vorgesehen, die im vorliegenden Fall als wesentliche Komponente nur eine magnetische Führungsvorrichtung 11 umfasst. Die magnetische Führungsvorrichtung 11 umfasst zwei Paare von Helmholtzspulen, die so ausgestaltet und angeordnet sind, dass ionisierte Targetionen 622, die mit einer Geschwindigkeit V vom Target her kommend in das durch die Helmholtzspulen erzeugte magnetische Führungsfeld der magnetischen Führungsvorrichtung 11 eindringen, durch die magnetische Führungskomponente 11 einer Oberfläche des Substrat S zugeführt werden. Ungeladene Teilchen und insbesondere die im wesentlichen ungeladenen Droplets 624 sind durch das magnetische Führungsfeld der Führungskomponente 11 in ihrer Bahn nicht beeinflussbar und werden daher durch die magnetische Führungskomponente 11, also hier durch das durch die Helmholtzspulen erzeugte magnetische Führungsfeld nicht auf die Oberfläche des zu beschichtenden Substrats S geführt. Vielmehr verfolgen die ungeladenen Droplets 624 ihre ursprüngliche Richtung und treffen entweder auf eine der Helmholtzspulen oder werden z.B. an einer Wand der Prozesskammer abgeschieden, wodurch die Droplets 624 ausgefiltert werden.

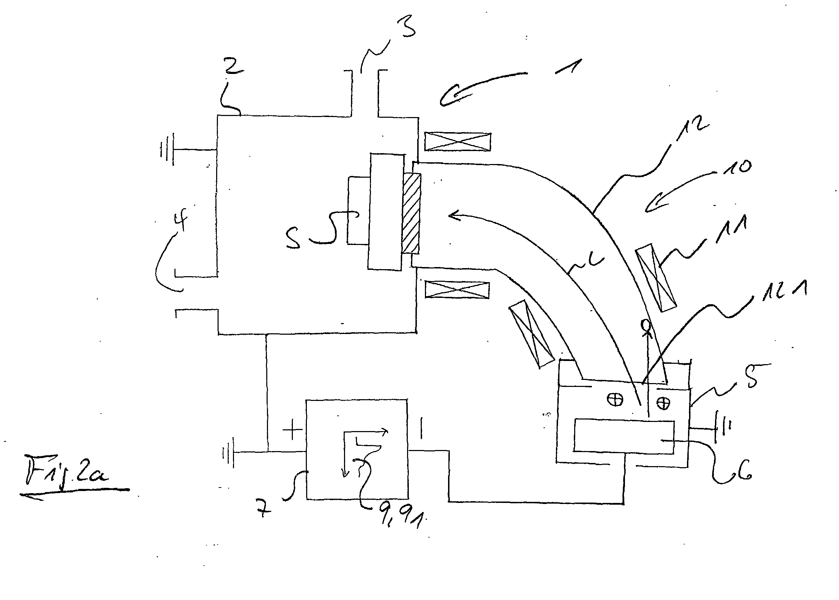

In Fig. 2 ist ein weiteres Ausführungsbeispiel gemäss Fig. 1 dargestellt, wobei die Filtereinrichtung 10 neben den magnetischen Führungskomponenten 11 einen entlang einer Längsachse L sich erstreckenden Schlauch 12 umfasst. Das aus dem Target 61 zerstäubte ionisierte Targetmaterial 622, sowie die Droplets 624 treten durch die Eintrittsöffnung 121 in den Schlauch 12 ein. Die ionisierten Teilchen 622 des Targetmaterials werden durch die magnetischen Führungskomponente 11 wie bei dem Ausführungsbeispiel der Fig. 1 zum Beschichten auf die Oberfläche des Substrats S geführt, das in der Nähe der Austrittsöffnung 122 des Schlauchs 12 angeordnet ist. Die im wesentlichen ungeladenen Droplets 624 werden durch die magnetische Führungskomponente 11 in ihrer Flugbahn praktisch nicht beeinflusst und werden an einer Innenwand des Schlauchs 12 abgeschieden. Durch Verwendung des Schlauchs 14 ist eine noch bessere Ausfilterung der Droplets 624 möglich.

Dabei kann die Filterungwirkung durch die Filtereinrichtung 10 durch eine kompliziertere Gestaltung der Geometrie des Schlauchs 12 noch weiter verbessert werden. Der in Fig. 2 dargestellte Schlauch 12 weist dabei eine Krümmung α von ca. 90° auf. Selbstverständlich kann der Krümmungswinkel α je nach Anforderung auch einen grösseren oder kleineren Wert als 90° haben.

In Fig. 2a ist ein Ausführungsbeispiel einer erfindungsgemässen Beschichtungsvorrichtung 1 dargestellt, bei welcher der Schlauch 12 ausserhalb der Prozesskammer 2 angeordnet ist. Der Schlauch 12 mit Target 6 und Zerstäuubungsquelle 8 ist dabei so ausgestaltet und angeordnet, das der Schlauch 12 selbst im wesentlichen ganz ausserhalb der Prozesskammer 2 vorgesehen ist und die Austrittsöffnung 121 des Schlauchs 12 mit einer Öffnung der Prozesskammer 2 derart zusammenwirkt, dass das ionisierte Targetmaterial 622 aus dem Schlauch 12 ins innere der Prozesskammer 2 zur Beschichtung des in der Prozesskammer 2 angeordneten Substrats S führbar ist. Diese Variante hat den besonderen Vorteil, dass die Beschichtungskammer 2 relativ klein gehalten werden kann und der Schlauch 12 besonders leicht austauschbar ist.

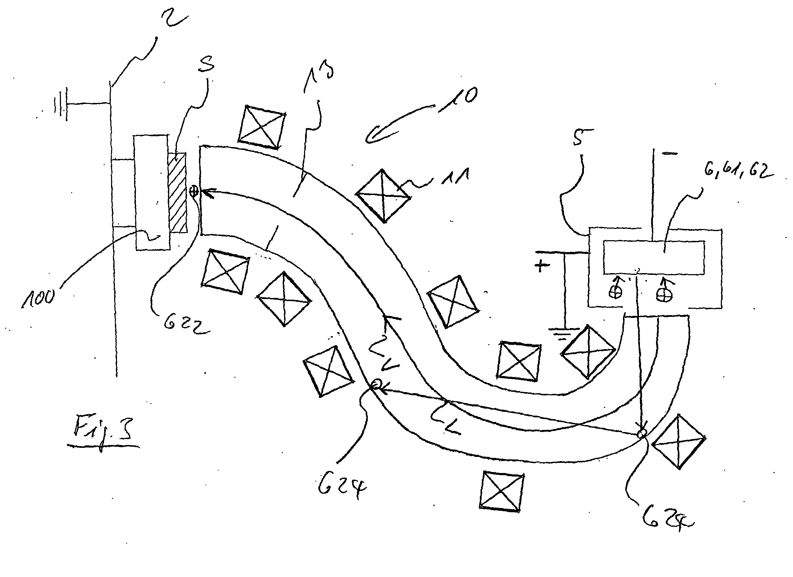

Komplizierte Geometrien des Schlauch 12, wie beispielsweise der in Fig. 3 gezeigte mehrfach gebogene Schlauch 12 erlauben die Herstellung höchst gleichmässiger Schichten von besonders hoher Qualität, weil auch Droplets, die beispielsweise nach einer Reflexion an einer geeigneten Stelle innnerhalb des Schlauchs 12 die Oberfläche des Substrats S noch erreichen können, in der komplizierten Geometrie des Schlauchs 12 der Fig. 3 ebenfalls herausgefiltert werden können. Desweiteren kann die Führungseinrichtung 10 zusätzlich eine oder mehrere Rückhalteblenden 13 als Partikelfalle umfassen. Dabei kann die Rückhalteblende 13 z.B. wie in Fig.3 dargestellt im Schlauch 12 angeordnet sein. Ausserdem ist es möglich, dass der Schlauch entlang seiner Längsachse in Durchmesser oder Form variiert, wodurch ebenfalls Partikelfallen für das Herausfiltern unerwünschter Partikel realisierbar sind, oder der Schlauch 12 kann an seiner Innenseite eine gerippte Struktur aufweisen, die als Patrikelfalle für nicht ionisierte Teilchen wirkt.

Aber auch bei Ausführungsbeispielen der erfindungsgemässen Beschichtungsvorrichtung 1, bei welchem kein Schlauch 12 vorgesehen ist, wie z.B. bei der Beschichtungsvorrichtung 1 gemäss Fig. 1 können entlang des Weges des ionisierten Targetmaterials 622 geeignet Rückhalteblenden 13 als Partikelfalle für die Droplets vorgesehen sein.

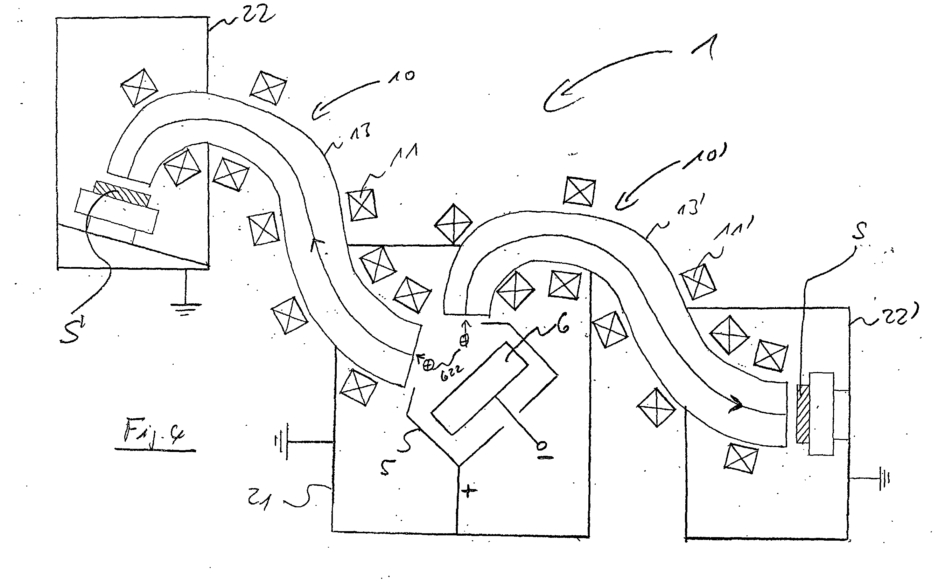

In Fig. 4 ist eine Beschichtungsvorrichtung 1 mit separater Zerstäubunggskammer 21 und zwei Beschichtungskammern (22, 22') exemplarisch dargestellt. In der Zerstäubungskammer 21 ist die Anode 5 und die Kathode 6 angeordnet, so dass in der Zerstäubungskammer 21 das Targetmaterial 62 zerstäubt und, wie bereits eingehend erläutert, nach-ionisiert wird. Die Ionisierungsmittel 9 sind dabei der Übersichtlichkeit halber in Fig. 4 nicht dargestellt. Zwei zu beschichtende Substrate S und S' sind in zwei verschiedenen Beschichtungskammern 22 und 22' angeordnet. Die Zerstäubungskammer 21 bildet zusammen mit den Beschichtungskammern 22 und 22' gesamthaft die Prozesskammer 2 der Beschichtungsvorrichtung 1. Jede der Kammern kann über einen eigenen, hier nicht dargestellten Einlass 3 und Auslass 4 für ein Prozessgas verfügen. Dadurch ist es möglich, je nach Anforderungen in den verschiedenen Kammern verschiedene Gasatmosphären herzustellen. Insbesondere kann durch die geeignete separate Steuerung und / oder Regelung der beiden magnetischen Führungskomponenten 11 und 11' der beiden verschiedenen Filtereinrichtungen 10 und 10' die Beschichtung der beiden Substrate unabhängig voneinander und unabhängig von der Zerstäubung des Targets 61 in der Zerstäubungskammer 21 kontrolliert werden, so dass z.B. auf dem Substrat S eine andere Beschichtung, z.B. mit anderen Eigenschaften oder anderer Zusammensetzung als auf dem Substrat S' aufgebracht werden. So kann unter anderem die Rate der zur Beschichtung zur Verfügung stehenden ionisierten Teilchen dadurch reduziert werden, dass im Schlauch 13, 13' durch geeignete Einstellung des magnetischen Führungsfeldes der Teilchenstrom teilweise so gelenkt wird, dass er vor Erreichen der Oberfläche des Substrats S, S' an einer in Fig. 4 nicht dargestellten Partikelfalle oder aber durch die Wände des Schlauchs 13, 13' abgefangen werden.

Auch ist es denkbar, dass z.B. im Schlauch oder an anderer geeigneter Stelle eine spezielle steuer- und / oder regelbare Elektronenquelle vorgesehen ist, so dass die Konzentration der Ionen 622 des Targetmaterials im Schlauch einstellbar ist, wodurch der fortschreitende Beschichtungsvorgang einstellbar ist.

Dabei versteht es sich von selbst, dass z.B. auch mehr als zwei Beschichtungskammern vorgesehen sein können oder, dass verschiedene Substrate S und S' über verschiedene Filtereinrichtungen 10 und 10' auch in einer gemeinsamen Prozesskammer beschichtet werden können, in der eventuell auch die Zerstäubungsanordnung aus Anode, Kathode und Ionisierungsmittel untergebracht sein können.

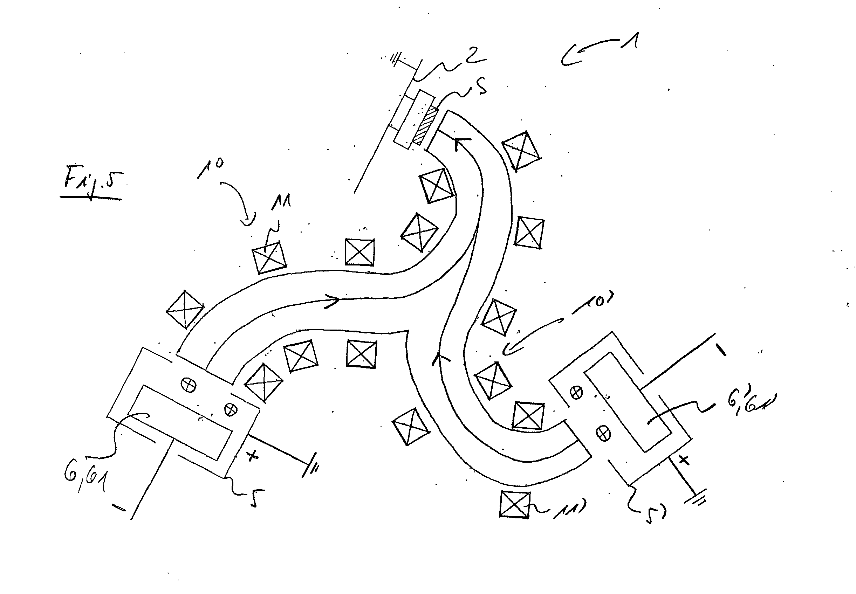

In Fig. 5 ist eine Beschichtungsvorrichtung 1 mit zwei Zerstäubungsanordnungen mit Kathoden 6, 6' und Anoden 5, 5' dargestellt. Aus Gründen der Übersichtlichkeit ist die Prozesskammer 2 nur andeutungsweise dargestellt. Die zwei Zerstäubungsanordnungen mit Kathoden 6, 6' und Anoden 5, 5' können dabei jeweils in einer separaten Zerstäubunggskammer 21 (in Fig. 5 nicht dargestellt) untergebracht sein, wobei das Substrat S in einer entsprechenden separaten Beschichtungskammer 22, die in Fig. 5 ebenfalls nicht gezeigt ist, angeordnet sein kann. Es versteht sich, dass auch die zwei Zerstäubungseinheiten in einer gemeinsamen Zerstäubungskammer 21 angeordnet sein können und das Substrat in einer eigenen Beschichtungskammer 22 plaziert sein kann. In einem speziellen Fall kann auch die gesamte in Fig. 5 gezeigte Anordnung in ein und derselben Prozesskammer 2 untergebracht sein, oder z.B. eine Zerstäubungseinheit gemeinsam mit dem Substrat S in einer Prozesskammer montiert sein, während die zweite Zerstäubungseinheit in einer separaten Zerstäubungskammer 21 vorgesehen ist.

Bei dem Ausführungsbeispiel einer erfindungsgemässen Beschichtungsvorrichtung gemäss Fig. 5 ist das Substrat gleichzeitig oder nacheinander mit zwei gleichen oder verschiedenen Materialien von zwei verschiedenen Targets beschichtbar. Dabei ist es auch hier möglich, je nach Anforderungen und wenn das Substrat und die Zerstäubungseinheiten in verschiedenen Kammern angeordnet sind, in den verschiedenen Kammern gleiche oder verschiedene Gasatmosphären herzustellen.

Insbesondere kann durch die geeignete separate Steuerung und / oder Regelung der beiden magnetischen Führungskomponenten 11 und 11' der beiden verschiedenen Filtereinrichtungen 10 und 10' und / oder der beiden Zerstäubungsanordnungen die Beschichtung des Substrats unabhängig voneinander und unabhängig von der Zerstäubung des jeweiligen anderen Targets 61, 61' kontrolliert werden, so dass eine hohe Flexibilität bezüglich der auf das Substrat aufzubringenen Schichten und deren Eigenschaften erreicht wird. So kann z.B. die Rate der zur Beschichtung zur Verfügung stehenden ionisierten Teilchen aus einem der beiden Zerstäubunseinheiten dadurch reduziert werden, dass im Schlauch 13, 13' durch geeignete Einstellung des magnetischen Führungsfeldes der Teilchenstrom teilweise so gelenkt wird, dass er vor Erreichen der Oberfläche des Substrats S an einer in Fig. 5 nicht dargestellten Partikelfalle oder aber durch die Wände des Schlauchs 13, 13' abgefangen wird oder es kann, wie zuvor erläutert, eine Elektronenquelle im Schlauch vorgesehen sein.

Dabei versteht es sich von selbst, dass z.B. auch verschiedene Substrate S und S' beschichtet werden können, z.B. indem das Ausführungsbeispiel aus Fig. 4 mit den Merkmalen des Beispiels aus Fig. 5 kombiniert wird. Auch kann das Substrat S mit mehr als zwei Zerstäubungsanordnungen gleichzeitig oder nacheinander beschichtet werden.

Mit der erfindungsgemässen Beschichtungsvorrichtung zum Beschichten eines Substrats mittels Kathodenzerstäubung steht somit eine Vorrichtung zur Verfügung, mit welcher verschiedenste Substrate mit Schichten versehen werden können, die höchsten Qualitätsansprüchen genügen. Insbesondere können ultradünne Schichten, wie sie z.B. in der Elektronik, der Optik, der Mikromechanik, der Mikroelektronik, oder auch in der Nanosensorik oder Nanomotorentechnik, oder auch in ästhetischen oder anderen Anwendungen benötigt werden, durch den Einsatz der an sich bekannten Hochleistungssputtertechnik erstmals frei von Droplets hergestellt werden, deren Entstehung, z.B. durch Mikrobogenentladungen, auch beim Sputtern nicht vollständig unterbunden werden kann. Durch die erfindungsgemässe Filtervorrichtung sind insbesondere diese Droplets zuverlässig herausfilterbar. Dadurch, dass durch das Führungsfeld der magnetischen Führungskomponente im wesentlichen nur elektrisch geladene Ionen des Beschichtungsmaterials die zu beschichtende Oberfläche des Substrats erreichen, ist zusätzlich eine Aktivierung und Reinigung der zu beschichtenden Oberflächen erreichbar, so dass mit der erfindungsgemässen Beschichtungsvorrichtung und dem erfindungsgemässen Verfahren Oberflächen allerhöchster Güte, die praktisch völlig fehlerfrei sind, selbst in ausserordentlich dünner Ausführung im Dickenbereich von wenigen Angström bis zu einigen Nanometern hergestellt werden können, wobei die maximal erzeugbare Schichtdicke selbstverständliche prinzipiell auch bedeutend grösser sein kann.

## Patentansprüche

1. Beschichtungsvorrichtung zum Beschichten eines Substrats (1) mittels Kathodenzerstäubung, umfassend eine Prozesskammer (2) zur Errichtung und Aufrechterhaltung einer Gasatmosphäre, die einen Einlass (3) und einen Auslass (4) für ein Prozessgas aufweist, sowie:
- eine Anode (5) und eine Kathode (6) mit einem Target (61) aus dem zu zerstäubenden Targetmaterial (62);
- eine elektrische Energiequelle (7) zur Erzeugung einer elektrischen Spannung zwischen der Anode (5) und der Kathode (6), wobei
- die elektrische Energiequelle (7) eine elektrische Zerstäubungsquelle (8) umfasst, mit welcher das Targetmaterial (62) der Kathode (6) durch Zerstäubung in eine Dampfform überführbar ist,
- und Ionisierungsmittel (9) zur Erzeugung einer elektrischen Ionisierungspannung (91) vorgesehen sind, so dass das zerstäubte Targetmaterial (62) zumindest teilweise ionisierbar ist,
**dadurch gekennzeichnet, dass**
eine Filtereinrichtung (10) mit einer magnetischen Führungskomponente (11) vorgesehen ist, welche Filtereinrichtung (10) derart ausgestaltet und angeordnet ist, dass das zerstäubte ionisierte Targetmaterial (622) durch die magnetische Führungskomponente (11) einer Oberfläche des zu beschichtenden Substrats (1) zuführbar ist und das zerstäubte nicht-ionisierte Targetmaterial (623, 624) durch die Filtereinrichtung (10) vor Erreichen der Oberfläche des Substrats (S) ausfilterbar ist.

2. Beschichtungsvorrichtung nach Anspruch 1, wobei die Filtereinrichtung (10) zumindest einen, in Form eines entlang einer Längsachse (L) sich erstreckenden Schlauchs (12) ausgebildeten Abschnitt umfasst, der eine Eintrittsöffnung (121) und eine Austrittsöffnung (122) für das zerstäubte Targetmaterial (62) aufweist.

3. Beschichtungsvorrichtung nach Anspruch 2, wobei der Schlauch (12) in Bezug auf die Längsachse (L) in einer Krümmungsebene mindestens eine Biegung mit einem vorgebbaren Biegungswinkel (α) aufweist.

4. Beschichtungsvorrichtung nach einem der Ansprüche 2 oder 3, wobei der Schlauch (12) in Bezug auf eine Krümmungsebene mehrere Biegungen in entgegengesetzte Richtungen aufweist.

5. Beschichtungsvorrichtung nach einem der Ansprüche 2 bis 4, wobei der Schlauch (12) in Bezug auf mindestens zwei verschiedene Krümmungsebenen Biegungen aufweist.

6. Beschichtungsvorrichtung nach einem der Ansprüche 2 bis 5, wobei der Schlauch (12) in einem vorgebbaren Abschnitt bezüglich der Längsachse (L) spiralförmig ausgebildet ist.

7. Beschichtungsvorrichtung nach einem der vorangehenden Ansprüchen, wobei die magnetische Führungskomponente (11) zur Erzeugung eines magnetischen Führungsfeldes eine elektrische Magnetsspule, bevorzugt eine Helmholtzspule umfasst.

8. Beschichtungsvorrichtung nach einem der vorrangehenden Ansprüche, wobei die magnetische Führungskomponente (11) zur Erzeugung eines magnetischen Führungsfeldes einen Permanentmagneten umfasst.

9. Beschichtungsvorrichtung nach einem der vorangehenden Ansprüche, wobei zur Filterung von nicht-ionisiertem zerstäubtem Targetmaterial (623, 624) mindestens eine Rückhalteblende (13) als Partikelfalle vorgesehen ist.

10. Beschichtungsvorrichtung nach einem der vorangehenden Ansprüche, wobei zur Neutralisation des Prozessgases und / oder des gesputterten Materials, insbesondere zur Neutralisation von Argon, eine Elektronenquelle zur Injektion von Elektronen vorgesehen ist, mit welcher Ionen des Prozessgases neutralisierbar sind.

11. Beschichtungsvorrichtung nach einem der vorangehenden Ansprüche, wobei das Substrat (1) und / oder ein Substrathalter (100) auf ein vorgebbares elektrisches positives oder negatives Potential einstellbar ist.

12. Beschichtungsvorrichtung nach einem der vorangehenden Ansprüche, wobei die Prozesskammer (2) eine Zerstäubungskammer (21), in welcher die Kathode (6) angeordnet ist, und eine Beschichtungskammer (22), in welcher das Substrat (S) angeordnet ist, umfasst.

13. Beschichtungsvorrichtung nach einem der vorangehenden Ansprüche, wobei mehr als eine Kathode (6) und / oder mehr als eine Anode (5) vorgesehen ist.

14. Beschichtungsvorrichtung nach einem der vorangehenden Ansprüche, wobei die Beschichtungsvorrichtung derart ausgestaltet ist, dass mindestens zwei verschiedene Substrate (S) beschichtbar sind.

15. Beschichtungsvorrichtung nach einem der vorangehenden Ansprüche, wobei mehr als eine Zerstäubungskammer (21) und / oder mehr als eine Beschichtungskammer (22) vorgesehen ist.

16. Beschichtungsvorrichtung nach einem der vorangehenden Ansprüche, wobei das Target (61) Kohlenstoff oder Kohlenstoffverbindungen umfasst.

17. Beschichtungsvorrichtung nach einem der vorangehenden Ansprüche, wobei das Target (61) Metalle oder Metalllegierungen, insbesondere Kupfer umfasst.

18. Beschichtungsvorrichtung nach einem der vorangehenden Ansprüche, wobei, bevorzugt an der Kathode (6), ein Magnetron (600) vorgesehen ist.

19. Beschichtungsvorrichtung nach einem der vorangehenden Ansprüche wobei, bevorzugt an der Kathode (6), ein balanziertes Magnetron (601) vorgesehen ist.

20. Beschichtungsvorrichtung nach einem der vorangehenden Ansprüche, wobei, bevorzugt an der Kathode (6), ein unbalanziertes Magnetron (602) vorgesehen ist.

21. Verfahren zum Beschichten eines Substrats (S) mittels Kathodenzerstäubung in einer Beschichtungsvorrichtung (1) umfassend::
- eine Prozesskammer (2) mit einem Einlass (3) und einem Auslass (4) für ein Prozessgas zur Errichtung einer Gasatmosphäre;
- eine Anode (5) und eine Kathode (6) mit einem Target (61) aus einem Targetmaterial (62), das zur Beschichtung des Substrats (S) zerstäubt wird;
- eine elektrische Energiequelle (7), mit welcher eine elektrische Spannung zwischen der Anode(5) und der Kathode (6) erzeugt wird, wobei
- die elektrische Energiequelle (7) eine elektrische Zerstäubungsquelle (8) aufweist, mit welcher das Targetmaterial (62) der Kathode (6) durch Zerstäubung in eine Dampfform überführt wird,
- und ein Ionisierungsmittel (9) zur Erzeugung einer elektrischen Ionisierungsspannung (91) vorgesehen ist, mit welcher das zerstäubte Targetmaterial (62) zumindest teilweise ionisiert wird,
**dadurch gekennzeichnet, dass**
eine Filtereinrichtung (10) mit einer magnetischen Führungskomponente (11) vorgesehen ist, welche Filtereinrichtung (10) derart ausgestaltet und angeordnet ist, dass das zerstäubte ionisierte Targetmaterial (622) durch die magnetische Führungskomponente (11) einer Oberfläche des zu beschichtenden Substrats (S) zumindest teilweise zugeführt wird und das zerstäubte nicht-ionisierte Targetmaterial (623, 624) durch die Filtereinrichtung (10) vor Erreichen der Oberfläche des Substrats (S) zu einem vorgegebenen Anteil ausgefiltert wird.

22. Substrat, insbesondere ein optisches oder elektronisches Bauteil, im speziellen eine Computerfestplatte, das mittels einer Beschichtungsvorrichtung (1) nach einem der Ansprüche 1 bis 20 oder nach einem Verfahren nach Anspruch 21 beschichtet ist.
